Europäisches Patentamt

**European Patent Office**

Office européen des brevets

(11) Veröffentlichungsnummer: **0 005 164**
**B1**

(12) **EUROPÄISCHE PATENTSCHRIFT**

(45) Veröffentlichungstag der Patentschrift:
04.11.81

(51) Int. Cl.³: **H 01 L 21/31, H 01 L 21/265**

(21) Anmeldenummer: **79100948.3**

(22) Anmeldetag: **29.03.79**

(54) **Verfahren zur Herstellung integrierter logischer Schaltungen in Implantationstechnik mit gehärteter Photoresistmaske.**

(30) Priorität: **28.04.78 US 900844**

(43) Veröffentlichungstag der Anmeldung:
**14.11.79 Patentblatt 79/23**

(45) Bekanntmachung des Hinweises auf die Patenterteilung:
**04.11.81 Patentblatt 81/44**

(84) Benannte Vertragsstaaten:
**DE FR GB**

(56) Entgegenhaltungen:
**DE-A-2 503 171**
**DE-B-2 534 132**
**US-A-4 110 126**
**IBM Technical Disclosure Bulletin, Band 16, Nr. 5, Oktober 1973, New York,**
**R. P. Esch, »Double-coating method using positive resist«**

(73) Patentinhaber: **International Business Machines Corporation, Armonk, N.Y. 10504 (US)**

(72) Erfinder: **Alcorn, George Edward, 2363 Glade Bank Way, Reston, Va. 22091 (US)**
Erfinder: **Bergeron, David Leo, 21 Dufresne Drive, Winooski, VT 05404 (US)**
Erfinder: **Stephens, Geoffrey Brownell, 1320 Yubinaranda Circle, Cary North Carolina 27511 (US)**

(74) Vertreter: **Rudolph, Wolfgang, Schönaicher Strasse 220, D-7030 Böblingen (DE)**

Verfahren zur Herstellung integrierter logischer Schaltungen in Implantationstechnik
mit gehärteter Photoresistmaske

Die Erfindung betrifft ein Verfahren zur Herstellung integrierter logischer Schaltungen durch Ionenimplantation gemäß dem ersten Teil des Anspruchs 1, sowie dessen Verwendung zur gleichzeitigen Herstellung lateraler PNP und vertikaler NPN-Transistoren.

Ein derartiges Verfahren ist aus der DE-B-2 534 132 bekannt.

Eine Verkleinerung und die Selbstausrichtung der Maskenausschnitte würde die Bildung eines Transistors mit kleinerer PNP-Emitter-Basis-Kapazität, einer niedrigeren aufwärts gerichteten NPN-Kollektor-Basis-Kapazität, einem niedrigeren PNP-Basis-Reihenwiderstand und einer höheren Wahrscheinlichkeit für die Vermeidung von Kollektor-Emitter-Leitungsdefekten gestatten. Bisher war die Technik jedoch nicht in der Lage, selbstausrichtende Kontakt- und Schutzringausschnitte in der Größenordnung von ein Mikron oder darunter herzustellen, und so die praktische Ausbildung einer Transistorschaltung geringster Größe oder eines Transistorspeichers mit einer Mindestzahl kritischer Masken und heißer Verarbeitungsschritte zu ermöglichen.

In der US-Patentschrift Nr. 4 009 057 wird ein Prozeß zur Bildung eines vertikalen NPN-Transistors beschrieben, in dem eine Oxidschicht gebildet wird, durch die alle Kontaktbohrungen geätzt werden. In den nachfolgenden Schritten werden verschiedere Konbinationen dieser Ausschnitte selektiv mit einer Photoresistschicht und Ionenimplantationen durch die Öffnungen im Photoresist gesperrt. In dem beschriebenen Verfahren wird die markierende Oxidschicht entfernt und später eine Passierungsschicht gebildet. Dabei kann ein doppelt deffundierter, lateraler PNP nicht hergestellt werden, da eine dicke Oxidschicht um die für die Oxidation undurchdringlichen maskierenden Nitridschichten 5 eine Konfiguration bildet, die die laterale PNP-Basis verbraucht. Die Dicke der Oxidschicht von etwa 600 nm würde außerdem dazu führen, daß sich die Nitridschicht bei Ausschnittgrößen von ungefähr ein Mikron abhebt. Außerdem würde die Spannung im Emitter-Basis-Bereich des lateralen PNP, die auf die Verschiebung der Nitridschicht durch die Oxidschicht zurückzuführen ist, zu größeren Rekombinationslagen führen, die die Leistung des resultierenden Elementes insbesondere beim Betrieb mit niedrigen Strömen heruntersetzen.

Bei diesem herkömmlichen Prozeß muß eine Nitridschicht von der Oxidschicht durch Unterätzen der Nitridschicht abgehoben werden, was ein Prozeß mit niedriger Ausbeute ist.

In der EP-A-0 000 327 ist ein Verfahren zum Herstellen von integrierten Halbleiteranordnungen beschrieben, das durch Anwendung konventioneller photolithographischer Prozesse in Verbindung mit Sperrmasken, die keine kritische Ausrichtung erforderlich machen, mehr als zwei unterschiedliche Zonen in einem Halbleiterkörper selbstausrichtend herstellbar macht. Das Verfahren selbst ist dadurch charakterisiert, daß auf den Halbleiterkörper übereinanderliegend drei unabhängig voneinander ätzbare Maskierungsschichten aufgebracht werden, daß in die erste oberste Maskierungsschicht ein der Gesamtmenge der zu bildenden Zonen entsprechendes Maskenmuster geätzt wird, wobei die zweite, mittlere Schicht als Ätzstop dient, und daß jeweils nach einem ersten, einem zweiten und einem dritten selektiven Abdecken des Musters in der ersten Maskierungsschicht mit einer entsprechenden ersten, zweiten und dritten Sperrmaske mindestens in die zweite Maskierungsschicht unter Verwendung der ersten Maskierungsschicht als Ätzmaske nacheinander einer ersten, zweiten und dritten Teilmenge der zu bildenden Zonen entsprechende Maskenmuster geätzt und entsprechende Zonenmuster in den Halbleiterkörper eingebracht werden.

Aus der DE-A-2 503 171 ist ein Photolack-Ätzverfahren zur Herstellung von Halbleiteranordnungen bekannt, das Masken aus zwei übereinanderliegenden Photoresistschichten verwendet.

Der Erfindung liegt deshalb die Aufgabe zugrunde, ein verbessertes Verfahren zur Herstellung integrierter logischer Schaltungen durch Ionenimplantation, bei dem auf einem Halbleitersubstrat oder auf einer auf ihm befindlichen Schicht eine Hauptmaskenschicht niedergeschlagen wird, zu schaffen, das für die Herstellung von Löchern und Ausschnitten in der Größenordnung von einem $\mu$ und darunter trotz heißer Prozeßschritte geeignet ist, wobei ein auf alle Kontakte ausgerichteter Schutzring und nur von oben nach unten verlaufende Isolationsbereiche gebildet werden sollen, wobei auch ein doppelt diffundierter PNP-Transistor gebildet werden soll, dessen Basis mit der Durchführung bzw. dem Schutzring eines NPN-Transistors und dessen Kollektor mit der Basis des NPN-Transistors und dessen Emitter mit dem Basiskontakt des NPN-Transistors kompatibel sind.

Die erfindungsgemäße Lösung dieser Aufgabe besteht in einem Verfahren, das dadurch charakterisiert ist, daß als Hauptmaskenschicht eine erste Photorestistschicht verwendet wird und daß die erste Photoresistschicht nach dem Einbringen der Ausschnitte und vor dem erstmaligen Aufbringen einer der als Sperrmaskenschicht dienenden zweiten Photoresistschichten einem Härtungsprozeß unterworfen wird, der die dann ausgehärtete Photoresistschicht gegenüber einem Lösungsmittel für die zweiten, ungehärteten Photoresistschichten unempfindlich macht.

Eine weitere Ausgestaltung der Erfindung besteht darin, daß die Aushärtung der ersten Photoresistschicht naßchemisch erfolgt und daß danach zur Erhöhung der Widerstandsfähigkeit gegen die Auflösung in Lösungsmitteln eine Behandlung mit reaktiven Ionen erfolgt.

Eine weitere Ausgestaltung der Erfindung besteht darin, daß die zweite Photoresistschicht entfernt wird und durch eine andere auf der Oberfläche und den Ausschnitten der ersten gehärteten Photoresistschicht niedergeschlagenen Photoresistschicht ersetzt wird, wobei in diese Schicht selektiv mehrere Unterausschnitte über ausgewählten Ausschnitten in der ersten gehärteten Photoresistschicht gebildet werden.

Durch die Verwendung des erfindungsgemäßen Verfahrens läßt sich ein lateraler PNP-Transistor mit niedriger Emitter-Basisdiffusions-Kapazität und einem niedrigen Reihenwiderstand der Basis und außerdem ein vertikaler NPN-Transistor mit reduzierter Kollektorbasiskapazität und einer erhöhten Wahrscheinlichkeit der Vermeidung von Kollektor-Emitter-Leitungsdefekten herstellen.

Der Prozeß basiert auf dem Niederschlag einer ersten Photoresistschicht auf einem mit Oxid überzogenen oder blanken Halbleiter, wobei in der Photoresistschicht mehrere Ausschnitte gebildet und diese Schicht durch eine naßchemisch gehärtet wird, dann folgt eine Ionenimplantation, eine Behandlung mit einem reaktiven Plasma oder mit einer anderen reaktiven Ionentechnik, um so die Widerstandsfähigkeit der ersten Photoresistschicht gegen die Auflösung in Lösungsmitteln zu erhöhen. Über der Oberfläche und den Ausschnitten der ersten Schicht wird eine zweite Photoresistschicht niedergeschlagen und darin eine Untergruppe von Ausschnitten über ausgewählten Ausschnitten in der ersten Photoresistschicht so gebildet, daß ein Teil der Ausschnitte in der ersten Schicht selektiv abgeblockt wird. Diese erfindungsgemäß zusammengesetzte Maske kann dann für die Ionenimplantation, die Naßätzung oder die reaktive Plasmaätzung derjenigen Fläche des Oxids oder der Halbleiteroberfläche verwendet werden, die durch die zusammengesetzten Ausschnitte freigelegt ist. Die zweite Photoresistschicht kann dann entfernt und durch eine andere auf der Oberfläche und den Ausschnitten der ersten gehärteten Photoresistschicht niedergeschlagenen Photoresistschicht ersetzt werden. In dieser Ersatzschicht können selektiv mehrere Unterausschnitte über ausgewählten Ausschnitten in der gehärteten Photoresistschicht gebildet und dadurch eine andere Kombination von Ausschnitten in der ersten gehärteten Schicht selektiv abgeblockt werden.

Die Vorteile dieser Technik bestehen darin, daß dieser Prozeß bei niedrigen Temperaturen ablaufen kann und keine erneute Oxidation erfordert, wodurch weniger Fehler im Halbleitersubstrat induziert werden. Die gehärtete Photoresistmaske ist einfacher und genauer als Metallmasken und verlangt kein Unterätzen des Metalles. Wenn die gehärtete Photoresist-Hauptmaske auf eine oxidierte Schicht auf der Oberfläche eines Halbleitersubstrates gelegt wird, kann die Maske zur Ausbildung sowohl der Löcher im Oxid als auch zur Ausbildung der ionenimplantierten oder geätzten Struktur im Halbleitersubstrat verwendet werden, wodurch sich diese Strukturen selbst ausrichten.

Ein Ausführungsbeispiel ist in den beigefügten Zeichnungen dargestellt und wird anschließend näher beschrieben.

Es zeigt

Fig. 1 ein einer Schnittansicht ein Halbleitersubstrat mit einem vergrabenen N + -Bereich und einer darauf ausgebildeten epitaxialen Schicht sowie einer in der Oberfläche der epitaxialen Schicht ausgebildeten P-leitenden Schicht, der eine letzte Passivierungsschicht aus Siliziumdioxid folgt,

Fig. 2A eine Schnittansicht der in Fig. 1 gezeigten Struktur während eines späteren Produktionsschrittes, wenn eine Schicht aus Photoresistmaterial oben auf der Siliziumdioxidschicht niedergeschlagen wurde,

Fig. 2B eine Schnittansicht der in Fig. 2A dargestellten Struktur während eines späteren Schrittes, in dem das Muster der Hauptmaske in der Photoresistschicht ausgebildet wurde und diese Maske gehärtet wurde,

Fig. 3 eine Schnittansicht der in Fig. 2B dargestellten Struktur während eines späteren Schrittes, wenn eine erste selektive Photoresist-Blockierschicht auf der Hauptmaske niedergeschlagen ist,

Fig. 4 eine Schnittansicht der in Fig. 3 gezeigten Struktur während eines späteren Schrittes, wenn eine zweite blockierende Photoresistmaske über die Hauptmaske gezogen wurde und

Fig. 5 eine Schnittansicht der in Fig. 4 gezeigten Struktur während eines nachfolgenden Schrittes, wenn noch eine dritte selektiv blockierende Photoresistmaske auf die Hauptmaske gelegt wurde und sich so eine Anordnung bipolarer dynamischer Randomspeicherzellen bildete.

Die Implementierung einer dynamischen RAM-Zelle ist durch folgende Faktoren in der Praxis eingeschränkt:

1. Der aktive Basisbereich eines NPN-Transistors unterbricht die Oberfläche in an den Stellen, wo sie für die Inversion und somit eine Heraufsetzung der Stromverstärkung von der Oberflächenladung empfänglich ist.
2. Der PNP-Emitter injiziert Strom, der an drei Seiten des P-Isolationsbereiches gesammelt wird.
3. Das Verhältnis der NPN-Kollektor-Basis-Kapazität zur Emitter-Basis-Kapazität Emitter-Basis-Kapazitanz und somit der Unterscheidungspegel zwischen den Signalen 1 und 0 ist sehr niedrig.

Der hier beschriebene Prozeß bringt Verbesserungen bei jedem der oben gezeigten Nachteile und umfaßt eine Borionenimplantation ohne Maske zur Ausbildung der Isolation zwischen NPN-Basis und PNP-Kollektor und der oberen Isolation. Dieser P-Bereich wird hinterher in separate Bereiche durch N-leitende Phosphorimplantation unterteilt, die durch eine besondere Maskierungsfolge von selbst auf den NPN-Emitter und auf eine Seite des PNP-Emitter ausgerichtet ist. Die Implantationsdosen und Energien und die nachfolgenden Wärmebehandlungen sind so ausgelegt, daß sie eine gewissermaßen unabhängige Kontrolle der PNP-Emitter-Basis-Kapazität und der Kollektor-Basis-Kapazität gestatten.

Durch Wahl eines relativ hohen spezifischen Basiswiderstandes (ungefähr 1000 $\Omega/\square$) und einer Implantation mit doppelter Energie kann die Basiskonzentration und somit die Emitter-Basiskapazität niedrig gehalten werden. Die Kollektor-Basis-Kapazität wird durch die Konzentration der Phosphorimplantatation sowie das gesamte Basisprofil beeinflußt. Die Phosphorimplantation erstreckt sich vertikal durch die Basis und umgibt die Basis für die seitliche Isolation vollständig, so daß sich eine hohe Seitenwandkapazität ergibt.

Die Phosphorimplantation bildet auch die Grundlage für den doppelt diffundierten PNP. Der PNP ist auf drei Seiten maskiert, um so durch eine seitlich stark integrierte Basisdotierung die Injektion in benachbarte Isolations- oder Zellenbereiche zu verhindern.

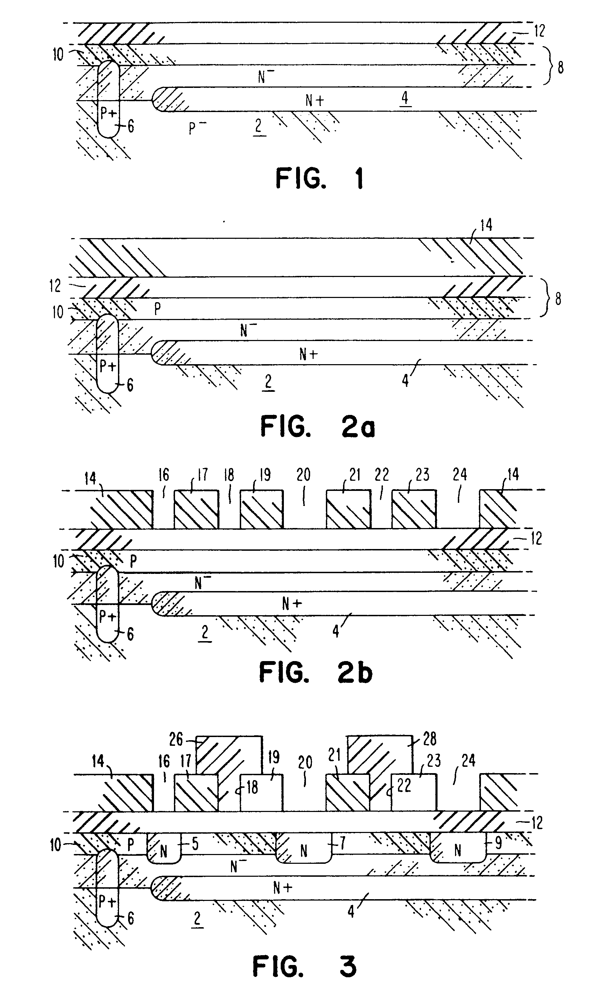

Die hier beschriebene Maskierungsfolge arbeitet mit einer Photoresistschicht, die einer Temperatur ausgesetzt wird, bei der das Resistmaterial für nachfolgende Photoresistanwendungen unlöslich und unbeweglich wird. Diese Maskierungsschicht wird durch eine Photomaske in der in den nachstehenden Fig. 1 bis 5 dargestellten Reihenfolge von Prozeßschritten definiert. Sie definiert die Ausschnitte für nachfolgende Ätzungen und Ionenimplantationen, die selektiv durch Photoresistschichten abgeblockt werden. Zum Abschluß einer jeden nachfolgenden Ätzung bzw. Implantation wird die blockierende Photoresistschicht entfernt, ohne daß die gehärtete Photoresistschicht entfernt und eine neue Schicht niedergeschlagen und belichtet werden muß.

Die in den Fig. 1 bis 5 gezeigte Prozeßschrittreihenfolge geht von einem nach einem herkömmlichen Prozeß hergestellten vergrabenen Kollektor, einer vergrabenen Isolation und einem epitaxialen Niederschlag aus, auf dem sich eine Oxidationsschicht befindet. Zur Definition dieser vergrabenen Bereiche werden eine erste und eine zweite Photolithographie eingesetzt.

Ohne Maske wird zuerst mit doppelter Energie ein Bohrprofil durch das Oxid in den N-Bereich implantiert, wie es in Fig. 1 gezeigt ist. Als nächstes wird die Maskierungsschicht 14 niedergeschlagen, und eine Hauptmaske durch eine dritte photolithographische Maske definiert. Die Hauptmaske 14 ist eine Photoresistmaske, die bei einer Temperatur von ungefähr 180° C gehärtet ist. Um die Definition der Ausschnitte in dieser temperaturgehärteten Maske zu erhalten, kann ein Zusatz zugegeben werden, der die Hauptmaske nicht mehr lichtempfindlich macht. Sie kann durch Veraschung entfernt werden. Mit Photoresiststandardtechniken läßt sich die temperaturgehärtete Hauptmaske 14 nicht entfernen.

Als nächstes wird die Durchführungs-Photoschicht aufgetragen und durch eine vierte photolithographische Maske die Sperrmasken 26 und 28 definiert. Die N-leitende Durchführung 5 wird durch Phosphorimplantation, deren Energie zum Einbringen in das Oxid 12 und den Basisbereich 10 nach Darstellung in Fig.3 ausreicht, gebildet.

Nach Entfernen der früheren Sperrmasken 26 und 28 wird eine neue zweite Photoresistschicht niedergeschlagen und durch eine fünfte photolithographische Maske die Sperrmasken 34, 36, 38 definiert. Diese Sperrmasken 34, 36, 38 sperren sowohl die nachfolgende Implantation und definieren eigentlich die Ausschnitte 37, 39 für die P+-Implantation 25 und 27 auf den drei Seiten des PNP-Emitters. Dadurch wird die PNP-Basis (N-Bereich) groß und die Basiskonzentration an den Seiten hochgehalten, wo die Injektion nicht erwünscht ist, und zwar ist das an den Seiten zu den Isolationsbereichen oder zu benachbarten Zellen.

Nach Entfernung dieser früheren Sperrmasken 34, 36 und 38, wird eine neue zweite Photoresistschicht aufgebracht und durch eine sechste lithographische Maske die Sperrmasken 30 und 32 definiert, die alle Bereiche mit Ausnahme des Bereiches, in dem Emitter 13 erwünscht sind, die vorher durch die Hauptmaske 14 definiert wurden, abblockt. Nach Ätzung des Oxides 12 in diesen Bereichen wird eine Arsenschicht 11, 13 und 15 bei ungefähr 50 keV und einer Dosierung von $8 \times 10^{15}$ cm$^{-2}$ implantiert, die beim Eintreiben durch den letzten Erhitzungsschritt den PNP-Emitter 13 und außerdem den Kollektorkontakt 11 bildet, wenn sie in Verbindung mit der früheren Phosphorimplantation benutzt wird.

Jetzt wird das ganze Photoresistmaterial entfernt — die gehärtete Hauptmaske 14 wird durch Veraschung entfernt.

Der letzte Erhitzungsschritt treibt den Arsen-Emitter 13, 15 ein und bestimmt die endgültige Lage der anderen implantierten Profile. Der dann folgende Prozeß ist ein herkömmlicher Schritt für die Verbindungen und die Metallanschlüsse.

Es ergibt sich eine auf alle Flächenkontakte und zwischen den aktiven Bereichen des Halbleiters selbst ausgerichtete Struktur. Eine gute Leistungsverfolgung ist gesichert durch Verwendung nur der einen Hauptmaske 14 zur Definition der Bilder und Abstände. Die Oberflächenkonzentration der Basis 10 kann unabhängig von der Eigendotierung der Basis hochgehalten werden. Der PNP-Emitter 25 und 27 kann so ausgelegt werden, daß nur Minoritätsträger in die NPN-Basis 10 injiziert werden. Außerdem wird so ein NPN-Halbleiter zur Verfügung gestellt, dessen Kollektor 8, Basis 10 und Emitter 13 oder 15 mit herkömmlichen photolithographischen Möglichkeiten kompatibel sind.

Fig. 1 zeigt einen Querschnitt der Struktur nach zwei photolithographischen Maskierungsschritten zur Definition der Lage eines vergrabenen N+-Bereiches 4 und eines vergrabenen P+-Isolationsbereiches 6 im P−-leitenden Substrat 2. Oben auf dem Substrat wird epitaxial die N−-leitende Siliziumschicht 8 aufgewachsen. Danach erfolgt eine Borimplantation in zwei Stufen, davon die erste mit einer Beschleunigungsspannung von 50 keV und die zweite mit einer Beschleunigungsspannung von 300 keV mit entsprechenden Dosierungen von etwa $10^{14}$ bzw. $10^{13}$ Atomen pro Quadratzentimeter. Die Epitaxialschicht 8 ist ungefähr zwei Mikron dick und das Bor-Implantationsprofil läuft etwa 0,8 Mikron unter die Oberfläche der Epitaxialschicht. Anschließend wird eine Siliziumoxidschicht 12 thermisch auf der Oberfläche der Epitaxialschicht 8 bis zu einer Dicke von etwa 300 nm aufgewachsen. Die in dieser Stufe im Herstellungsprozeß resultierende Struktur ist im Querschnitt der Fig. 1 gezeigt.

Fig. 2A zeigt den nächsten Schritt, wo eine Schicht aus Photoresistmaterial 14 auf der Oberfläche der Siliciumdioxidschicht 12 niedergeschlagen wird, die als Hauptmaske für die selektive Blockierung dient.

Fig. 2B zeigt den nächsten Herstellungsschritt indem die Photoresistschicht 14 chemisch, thermisch, durch Ionenimplantation oder in reaktiver Plasmatechnik gehärtet wird, nachdem in ihr das Hauptmuster ausgebildet wurde. Wenn die Photoresistschicht 14 beispielsweise aus dem oben erwähnten Material besteht, wird eine photolithographische Maske auf die Oberfläche der Photoresistschicht 14 und ein optisches Bildmuster so auf die Schicht gelegt, daß die Bereiche 16, 18, 20, 22 und 24 in einem Lösungsmittel löslicher gemacht werden. Für ein positives Photoresist würde das Licht die Abschnitte 16, 18, 20, 22 und 24 treffen, bei einem negativen Photoresist würden die Bereiche 16, 18, 20, 22 und 24 für das Licht durch eine Maske abgedeckt und die Teile 14, 17, 19, 21 und 23 der Hauptmaske belichtet. Das Ziel besteht jedoch in der Öffnung von Ausschnitten in diesen Bereichen, die in einer Reihe nachfolgender Maskierungsschritte unter Verwendung einer überlagernden abblockenden Maskierungsschicht ihre Position behalten.

Nachdem das Muster der Ausschnitte 16, 18, 20, 22 und 24 in der Photoresistschicht 14 gebildet ist, wird sie so gehärtet, daß sie in herkömmlichen Photoresistlösungsmitteln zum Ablösen der hinterher aufgetragenen blockierenden Maske unlöslich ist. Zu den Härtungsverfahren können das Erwärmen und Verfestigen der Photoresistschicht 14 zwecks weiterer Querverbindungen und die Herabsetzung ihrer Löslichkeit gehören. Das erwähnte Photoresistmaterial beispielsweise kann bei Temperaturen von etwa 180° C verfestigt werden, wodurch es für normale Lösungsmittel unlöslich wird. Es kann aber auch in eine Härtungslösung aus Natrium-2, Diazo-1, Oxynaphthalen-4 Sulfonat getaucht werden, wodurch die Photoresistschicht 14 gehärtet wird. Eine weitere Alternative ist die Behandlung der Oberfläche der Photoresistschicht 14 mit einem Ionenstrahl von einem Ionenimplantierer, beispielsweise mit Arsenionen, die mit 50 keV beschleunigt wurden, in einer Dosis von $5 \times 10^{15}$ cm−2. Auch Plasma von einer reaktiven Plasmaätzkammer kann zur Querverbindung eines Oberflächenteils der so freigelegten Photoresistschicht 14 dienen, wodurch sie widerstandsfähiger gegen eine Auflösung gemacht wird.

Fig. 3 zeigt einen nachfolgenden Schritt nach Ausbildung der gehärteten Hauptmaske in der Photoresistschicht 14, wo eine selektiv abblockende Schicht herkömmlichen Photoresistmaterials aufgetragen und zur Bildung der Sperrmasken 26 und 28 geformt wird, wodurch bei einer nachfolgenden Ionenimplantation die Implantation in den Ausschnitten 18 und 22 verhindert und die selektive Ionenimplantation in den Ausschnitten 16, 20 und 24 gestattet wird. Durch den in Fig. 3 gezeigten Ionenimplantationsschritt soll der N-leitende Schutzring sowie die N-leitenden Basisbereiche 7 und 9 für später ausgebildete PNP-Transistoren durch Implantation von Phosphorionen durch die Oxidschicht 12 mit einer Energie von ungefähr 400 keV gebildet werden.

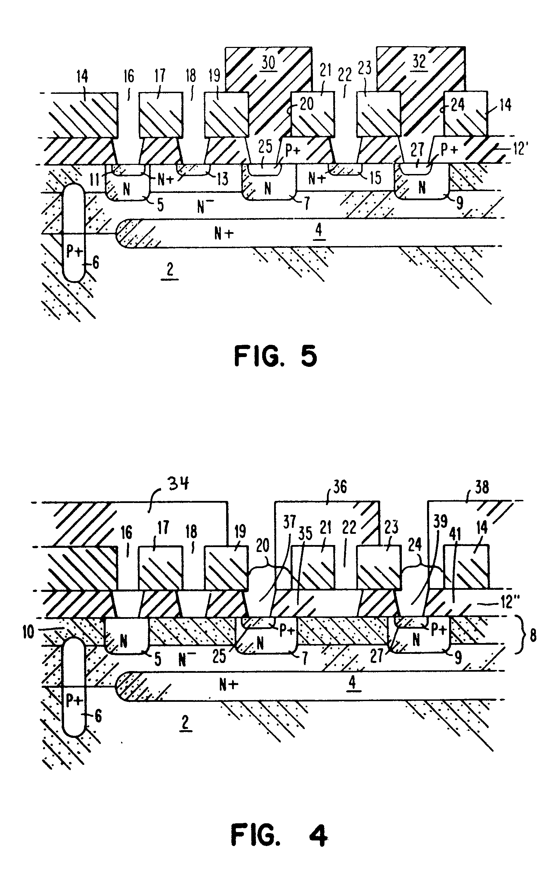

Fig. 4 zeigt einen Querschnitt der Struktur in einem nachfolgenden Schritt, wo die erste blockierende Photoresistschicht mit den Sperrmasken 26 und 28 mit herkömmlichen Lösungsmitteln entfernt und eine zweite blockierende Photoresistschicht über der Hauptmasse 14 aufgetragen wird und die Sperrmasken 34, 36 und 38 zur Maskierung der Ausschnitte 16, 18 und 22 beim Ätzen der Ausschnitte 37 und 39 gebildet werden. Der Sperrbereich 36 belegt ferner einen Teil des Originalausschnittes 20 und reduziert die Querschnittsfläche der resultierenden geätzten Öffnung 37 so, daß die resultierende ionenimplantierte Struktur 25 beispielsweise eine kleinere Fläche hat als die vorhergehende ionenimplantierte Struktur 27, die durch den relativ größeren Ausschnitt 20 belichtet wurde. Die linke Kante der P+-Struktur 25 ist in ihrer Lage definiert durch die entsprechende Kante des Hauptmaskenteils 19. Das ist wichtig, da die gebildete Struktur der PNP-Emitter 25 für einen lateralen PNP-Halbleiter ist, dessen Basisbereich der N-Bereich 7 und dessen Kollektorbereich der Teil des Basisimplantationsbereiches 10 ist, der direkt links vom Bereich 7 liegt, wie es in Fig. 4 gezeigt ist. Die Breite des Basisbereiches für den so gebildeten PNP-Transistor hat eine kritische Dimension, die genau durch die Ausrichtung der linken Seite des P+-Bereiches 25 auf die rechte Seite des Teils 19 der Hauptmaske definiert ist. Sowohl die linke Seite des PNP-Basisbereiches 7 als auch die linke Seite PNP-Emitterbereiches 25 sind durch dieselbe rechte Kante 19 der Hauptmaske ausgerichtet. Die P+-Ionenimplantation wird gebildet durch einen Borionenstrahl mit einer Beschleunigungsspannung von etwa 40 keV bei einer Dosierung von etwa $5 \times 10^{15}$ Atomen pro Quadratzentimetern.

Fig. 5 zeigt den Schritt nach dem Auslösen der selektiv blockierenden Sperrmasken 34, 36 und 38, die aus Photoresistmaterial, wie bei dem oben erwähnten Material bestehen, in einem herkömmlichen Lösungsmittel. Zu diesem Zeitpunkt wird eine dritte selektiv blockierende Photoresistmaske über die Hauptmaske 14 gelegt, die schon in dem in Fig. 3 gezeigten und beschriebenen Blockierungsschritt verwendet wurde. In der dritten selektiv blockierenden Maske ist ein solches Muster ausgebildet, daß die Sperrmasken 30 und 32, die die Ausschnitte 20 und 24 maskieren, gebildet werden, und so das Ätzen der Oxidschicht 12 unter diesen Ausschnitten und auch die Ionenimplantation durch diese Ausschnitte verhindert wird. Die Ausschnitte 16, 18 und 22 werden offen gelassen, so daß bei der nachfolgenden Ätzung mit gepufferter Flußsäure Ausschnitte unter den Ausschnitten 16, 18 und 22 ausgeätzt werden, und anschließend werden Arsenionen zur Bildung der N+-Bereiche 11, 13 und 15 implantiert. Der Bereich 11 ist der Schutzringkontakt, der Bereich 13 bzw. 15 der Emitter für einen abwärts injizierten NPN-Transistor oder der Kollektor für einen auswärts injizierten NPN-Transistor. Die Arsenionenimplantation wird mit einer Beschleunigungsspannung von etwa 50 keV bei einer Dosierung von etwa $8 \times 10^{15}$ Atomen pro Quadratzentimeter ausgeführt.

Jetzt wird die Hauptmaske nicht mehr gebraucht und daher mit der darüberliegenden dritten selektiv blockierenden Photoresistmaske durch Ätzen in einem $O_2$-Plasma bei etwa 500 Watt in einer reaktiven Ionenätzkammer während etwa 30 Minuten entfernt.

Dieser Prozeß kann sowohl auf in Injektionstechnik hergestellte integrierte logische Schaltelemente als auch auf bipolare dynamische Random-Speicherzellen angewandt werden.

Alle ionenimplantierten Strukturen müssen erhitzt werden und die Arsenemitter müssen bei einer Temperatur von etwa 1000°C in einem Formiergas während etwa 50 Minuten eingetrieben werden.

## Patentansprüche

1. Verfahren zur Herstellung integrierter logischer Schaltungen durch Ionenimplantation, bei dem auf einem Halbleitersubstrat oder auf einer auf ihm befindlichen Schicht eine Hauptmaskenschicht (14) niedergeschlagen wird, bei dem in der Hauptmaskenschicht Ausschnitte (16 bis 24) gebildet werden, welche sämtliche in das Halbleitersubstrat einzubringenden Zonen hinsichtlich ihrer Ausdehnung und ihres gegenseitigen Abstands definieren, bei dem auf die mit den Ausschnitten versehene Hauptmaskenschicht in einer die Zahl der erforderlichen Implantationsprozesse entsprechenden Wiederholung jeweils eine Sperrmaskenschicht (26, 28; 30, 32; 36, 38) aus einem Photoresist in einer für die jeweiligen zu implantierenden Ionen undurchdringbaren Dicke aufgebracht und nach der Implantation wieder entfernt wird, und bei dem in jede der Sperrmaskenschichten vor dem jeweiligen Ionenimplantationsschritt über der für diesen Implantationsschritt erforderlichen Ausschnitten der Hauptmaskenschicht Öffnungen eingebracht werden, so daß die nicht für die jeweilige Implantation verwendeten Ausschnitte der Hauptmaskenschicht (14) überdeckt bleiben und gegenüber der Ionenimplantation abgeblockt sind, dadurch gekennzeichnet, daß als Hauptmaskenschicht eine erste Photoresistschicht (14) verwendet wird und daß die erste Photoresistschicht (14) nach dem Einbringen der Ausschnitte und vor dem erstmaligen Aufbringen einer der als Sperrmaskenschicht dienenden zweiten Photoresistschichten (26, 32; 36, 38) einem Härtungsprozeß unterworfen wird, der die dann ausgehärtete erste Photoresistschicht gegenüber einem Lösungsmittel für die zweiten, ungehärteten Photoresistschichten unempfindlich macht.

2. Verfahren nach Anspruch 1, dadurch gekennzeichnet, daß die Aushärtung der ersten Photoresistschicht (14) naßchemisch erfolgt und daß danach zur Erhöhung der Widerstandsfähigkeit gegen die Auflösung in Lösungsmitteln eine Behandlung mit reaktiven Ionen erfolgt.

3. Verfahren nach den Ansprüchen 1 und 2, dadurch gekennzeichnet, daß die zweite Photoresistschicht entfernt wird und durch eine andere auf der Oberfläche und den Ausschnitten der ersten gehärteten Photoresistschicht (14) niedergeschlagenen Photoresistschicht ersetzt wird und daß in dieser Schicht selektiv mehrere Unterausschnitte über ausgewählten Ausschnitten in der ersten gehärteten Photoresistschicht (14) gebildet werden.

4. Verwendung des Verfahrens nach den Ansprüchen 1 bis 3 zur gleichzeitigen Herstellung lateraler PNP und vertikaler NPN-Transistoren.

## Claims

1. A process for the fabrication of integrated logic circuits by ion implantation, wherein a main masking layer is deposited on the semiconductor substrate or a layer formed thereon, wherein windows (16 to 24) are formed in the main masking layer to define the size and relative spacing of all the zones to be introduced into the semiconductor substrate, wherein a series of blocking masking layers (26, 28, 30, 32, 36, 38) each consisting of a photoresist layer of sufficient thickness, to be impermeable to the ions to be implanted, are deposited over the main masking layer, including the windows, one masking layer being deposited for each required implantation and being removed after the implantation, and wherein holes are introduced into each of the successively deposited blocking masking layers only over the windows in the main masking layer required for the next to be performed implantation process step, prior to the performance of the individual ion implantation process step so that the windows of the main masking layer (14) not required for the next to be performed implantation remain covered and are blocked against ion implantation, characterised in that the first photoresist layer (14) being used as the main masking layer is exposed to a hardening process prior to the formation of the windows and the deposition of the first one of the photoresist layers (26, 28, 30, 32, 36, 38) serving as the blocking masking layers, the hardening process being such that the hardened photoresist layer is insensitive to the solvent used to remove the second unhardened photoresist layers.

2. A process according to claim 1, characterised in that said photoresist layer ist hardened by a wet chemical technique and is subsequently treated by reactive ions to increase the resistivity against a dissolution in solvents.

3. A process according to claims 1 and 2, characterised by the removal of the second photoresist layer and its replacement by a third photoresist layer, deposited on the surface and the windows of the first hardened photoresist layer (14) and the selective formation of a multiplicity of subwindows in this third layer over selected windows in the first hardened photoresist layer (14).

4. Use of a process according to claims 1, 2 or 3 for the similtaneous fabrication of letaral PNP and vertical NPN transistors.

## Revendications

1. Procédé pour fabriquer des circuits logiques intégrés par implantation ionique, dans lequel on dépose sur un substrat semi-conducteur ou sur une couche disposée sur celui-ci; une couche de masquage principale (14); on forme dans la couche de masquage principale des ouvertures (16 à 24) qui définissent l'etendue et l'espacement mutuel de toutes les régions diffusées dans le substrat semi-conducteur; on dépose sur la couche de masquage principale comportant lesdites ouvertures une couche de masque de blocage (26, 28; 30, 32; 36, 38) d'une résine photosensible avec une épaisseur telle qu'elle soit impénétrable pour les ions à implanter, et ceci avec un nombre de répétition correspondant au nombre des étapes d'implantations nécessaires, la couche étant enlevée après chaque implantation; et on forme, dans chacune des couches de masquage de blocage des trous, avant l'étape d'implantation ionique au-dessous des ouvertures pratiquées dans la couche de masquage principale nécessaires pour cette étape d'implantation, de sorte que les ouvertures de la couche de masquage principale (14) non utilisées pour l'implantation correspondante restent protégées contre l'implantation ionique; ce procédé étant caractérisé en ce que l'on utilise comme couche de masquage principale une première couche de résine photosensible (14) et que cette couche (14) est soumise à un procédé de durcissement, effectué après la formation des ouvertures et avant la première application des secondes couches de résine photosensible (26, 28; 30, 32; 36, 38) servant de couches de masquage de blocage, ledit procédé de durcissement rendant la première couche de rérine photosensible durcie, insensible à un solvant des secondes couches de résine photosensible non durcies.

2. Procédé selon la revendication 1, caractérisé en ce que le durcissement de la première couche de résine photosensible (14) est obtenu par un procédé chimique du type humide et en ce que la couche est ensuite traitée par des ions réactifs pour augmenter la résistance contre la dissolution dans des solvants.

3. Procédé selon l'une quelconque des revendications 1 et 2, caractérisé en ce que la seconde couche de résine photosensible est enlevée et quélle est remplacée par une autre couche de résine photosensible déposée sur la surface et les ouvertures de la première couche de résine photosensible durcie (14), et en ce que l'on forme sélectivement dans cette couche plusieurs ouvertures secondaires des ouvertures sélectionnées dans la première couche de résine photosensible durcie (14).

4. Utilisation de ce procédé selon l'une quelconque des revendications 1 à 3 pour fabriquer simultanément des transistors latéraux PNP et verticaux NPN.

FIG. 1

FIG. 2a

FIG. 2b

FIG. 3

FIG. 5

FIG. 4